# EUROPEAN PATENT SPECIFICATION

(11) **EP 2 290 388 B1**
(45) Date of publication and mention of the grant of the patent: **23.09.2015**
(21) Application number: 10168649.1
(22) Date of filing: 07.07.2010
(51) Int. Cl.: G01R 31/36

(54) **Battery condition determination**
Batteriezustandsbestimmung
Détermination de l'état de la batterie

(30) Priority: 26.08.2009 SE 0950610
(43) Date of publication of application: 02.03.2011
(73) Proprietor: Scania CV AB, 151 87 Södertälje (SE)
(72) Inventor: Ledfelt, Gunnar, 155 91 Nykvarn (SE)
(74) Representative: Scania CV AB

(56) References cited:
- EP-A1- 1 632 781
- WO-A1-2009/060131
- JP-A- H09 281 199
- US-A- 5 537 390
- US-A- 5 963 010
- US-A1- 2004 212 351
- US-A1- 2006 097 577
- US-A1- 2007 096 743
- US-B2- 6 534 992

## Description

### Field of the invention

The present invention relates to a method for battery condition determination in a dual battery system as defined in the preamble of claim 1.

The present invention also relates to an arrangement for determining a battery condition in a dual battery system as defined in the preamble of claim 13.

The present invention also relates to a computer program and a computer program product implementing the methods of the invention.

### Related art and background of the invention

In vehicles, such as cars, trucks, tractors, and the like, as well as in vessels, such as ships and boats, motors and engines are used for driving the vehicles or vessels. When starting these motors, an electrically driven starter motor is usually used for cranking the motor until it runs by itself, i.e. without being driven by the starter motor.

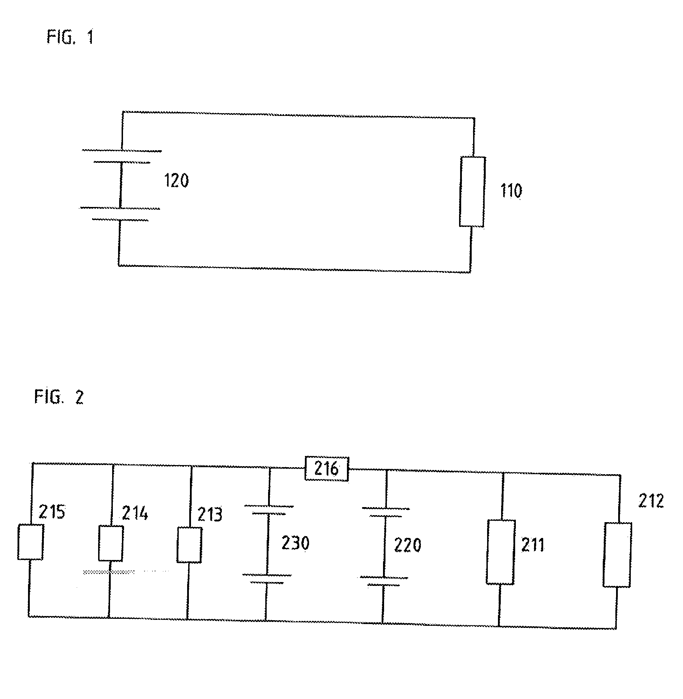

Figure 1 schematically shows a traditional battery system for e.g. a vehicle or a vessel, in which at least one Starting, Lighting and Ignition (SLI) battery 120 is used for providing Direct Current (DC) voltage to an electrical system 110, wherein the electrical system 110 includes the starter motor, a generator and a number of other electrical devices consuming DC current. These electrical devices include, for example, microprocessors, driver compartment heating systems, lights, audio systems, and video systems. Some of these devices may be used when the motor is not running, and will then be driven by DC voltage from the at least one SLI battery 120. In such a traditional battery system, the at least one SLI battery 120 generally has two functions, one function being to start the motor, by driving the starter motor, and the other function being to provide the electrical devices with electricity when the motor is not running.

Therefore, the at least one SLI battery 120 should be able to provide sufficient electrical power for both of these two functions. Thus, the at least one SLI battery 120 of the traditional battery system has to have both a high power and a good cycling capacity. High power is needed for the SLI battery to be able to drive the starter motor. Cycling capacity is needed, such that it can be run down and recharged a large number of times, due to usage of electrical devices when the motor is not running. Typically, high power abilities and good cycling capacity are contradictory features for batteries. Thus, for the traditional battery system used in figure 1, a compromise between these two features have to be found, such that the SLI battery can be used for both of these functions. The at least one SLI battery 120 is therefore normally designed so as to provide a battery being balanced between these two features. However, this leads to a suboptimal use of the at least one SLI battery 120, since it can not be optimized for both of the functions.

Figure 2 shows a prior art battery system having at least one power battery 220 and at least one starter battery 230, each providing electrical power for different purposes. Here, the at least one power battery 220 provides DC voltage to electrical devices being used when the motor is not running, such as lights 211 and heating systems 212. The at least one starter battery 230 provides electrical power to the starter motor 213. A generator 214 is used for charging the batteries. An Engine Management System (EMS) 215 controls the starter motor 213. An interconnection device 216 is here needed such that both batteries can be charged by the generator 214.

However, the system shown in figure 2 has the drawback of quiescent currents discharging the starter battery 230 through the EMS 215. Also, the interconnection device 216 is often implemented as a diode, for which case the power from the power battery 220 can not be utilised for activating the starter motor 213.

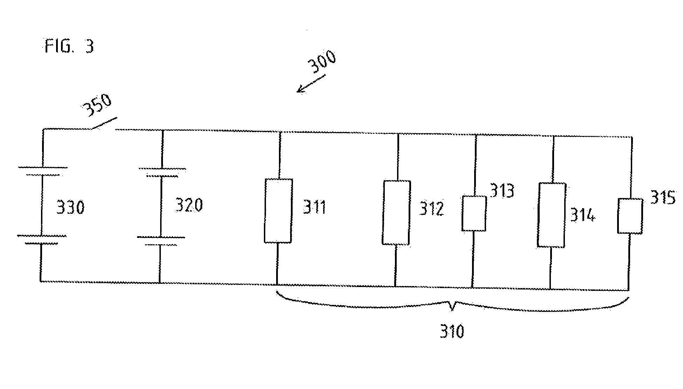

Figure 3 schematically shows a dual battery system 300, in which a power battery means 320, including at least one power battery, is connected to an electrical system 310. The electrical system 310 includes a starter motor 313 and battery charging means, including a generator 314. As stated above, the electrical system also includes electrical devices being used when the motor is not running, such as driver compartment heating 312, lights 311 and the like. Also, the electrical system 310 includes an EMS 315 controlling the starter motor 313. In the dual battery system 300, a starter battery means 330, including at least one starter battery, is connectable in parallel with the power battery means 320 by the use of a dual circuit breaker 350. Thus, when the dual circuit breaker 350 is closed, the starter battery means 330 and the power battery means 320 are coupled in parallel and together provide a dual system voltage to the electrical system 310. When the dual circuit breaker 350 is open, the power battery mean 320 alone provides electric power to the electrical system. Thus, the dual circuit breaker 350 is used to control the electrical power being provided to the electrical system, such that extra power can be provided from the starter battery means 330 when the starter motor 313 is to be activated.

In the dual battery system 300, the power battery means 320 is essentially only used for providing power to the electrical devices in the electrical system 310 when the motor is not running. Therefore, the power battery means 320 can be optimised regarding cycling capacity. Correspondingly, the starter battery means 330 is essentially only used for providing power to the starter motor 313, and can thus be optimised in regard of starting power characteristics. Thus, a more optimised battery system can be achieved.

Also, when charging the power battery means 320 and the starter battery means 330, the dual circuit breaker 350 can be used for connecting and/or disconnecting the starter battery means 330 to the charging means, where the charging means includes the generator 314.

However, batteries age during use and get aged after having been used for a period of time. This period of time varies for different kinds of batteries and for different manufacturers. Also, the period of time until a battery gets aged is dependent on how the battery has been used during its active lifetime. It is important for a driver or an owner of a vehicle or a vessel to be able to determine condition of its batteries, such that the driver or the owner can change the batteries before they compromise the operation of the vehicle or the vessel.

In prior art document US6534992, a method for determining performance of a single storage battery is presented. However, this method is very complex and impractical to utilise in a vehicle or a vessel, since advanced signal curve analysis has to be performed on a time profile of a voltage drop resulting when a heavy current load is applied to the single stored battery.

Further, in prior art document US2007096743, a battery deterioration determination method is disclosed, in which a voltage drop due to a resistance of the battery occurring in response to a discharge of the battery is used for the determination. In order for the determination to work properly, the discharge has to have a given current flow from the battery to the load, which makes this method complicated to implement and to use.

US 5 537 390 discloses a device for detecting residual capacity of a secondary battery.

Further, none of the presented prior art methods is developed for use in dual battery systems. Therefore, they do not utilise the features and possibilities being present in a dual battery system. Also, both of the disclosed prior art methods require that the battery is discharged to a load for a determination of a battery condition to be performed. This can be done either by discharging the battery one extra time, which would be a waste of energy, or by analysing a discharge in real time, which would require synchronisation of the battery condition determination method and the discharge. Such a synchronisation of course adds to the complexity of the implementation.

Thus, the disclosed prior art methods have a number of drawbacks. One main drawback relates to the complexity of the prior art methods. Also, the prior art solutions are impractical for implementation on a vehicle, since an extra discharge equipment is used. Thus, this extra discharge equipment has to be mounted on the vehicle, which adds to the weight of the vehicle. Also, the accuracy of the prior art methods is not good enough for dual battery system equipped vehicles or vessels.

### Aim and most important features of the invention

It is an object of the present invention to provide a method and an arrangement for determining a battery condition in a dual battery system that solves the above stated problem.

The present invention aims to provide a method and an arrangement for determining a battery condition, which offers a reliable and low complexity determination of battery conditions.

The object is achieved by the above mentioned method for battery condition determination in a dual battery system, according to the characterizing portion of claim 1.

The object is also achieved by the above mentioned arrangement for determining a battery condition in a dual battery system, according to the characterizing portion of claim 13.

The object is also achieved by the above mentioned computer program and computer program product, being arranged for implementing the methods of the invention.

The method and arrangement according to the present invention are characterized in that a correlation between the aging of the power batteries means, and the sizes of the differences between the dual system voltage and at least one of the open circuit power battery voltage and the open circuit starter battery voltage, respectively, is analysed over time. Thereby, a relative state of health for the power battery means can easily be determined, which is related to the state of health for the starter battery means. The voltages needed for performing this determination can easily be measured during relative long time periods, which results in a very low complexity determination. Also, these measurements, and also the determination, can be performed during normal operation, since no separate discharge is needed.

The present invention utilizes the improved starting performance of the dual battery system to lower the complexity. Generally, the outstanding starting performance of the dual battery system more or less guaranties that the cranking will be performed successfully and that the motor will be made to start. Therefore, a state of charge determination for the batteries is less important in the dual battery system. This is taken advantage of in the present invention by, instead of performing a complicated and complex estimation of the momentary level of state of charge for the batteries, determining the state of health over time. Also, since no extra discharge equipment is used by the present invention, the invention is very practical and easily implemented in a vehicle.

Typically, the condition of the starter battery means is relatively good. Therefore, the determined relative state of health for the power battery means can often be directly utilized for determining a more or less absolute measure for the state of health for the power battery means. Thereby, an estimation of the absolute state of health for the power battery means can be determined at a low level of complexity, and with a higher accuracy than for the prior art methods.

According to an embodiment of the invention, the state of health for the starter battery means is determined, and then, based on that determined state of health for the starter battery means and the determined relative state of health for the power battery means, an absolute measure for the state of health for the power battery means is determined. By this embodiment, a very exact and efficient determination for the battery condition determination is achieved.

According to an embodiment of the present invention, if the starter battery means is non-aged, the power battery means is considered to be essentially aged at a point in time if the difference between said dual system voltage and the open circuit starter battery voltage has reduced over time to be approximately 0%-30% of the battery voltage difference, and preferably 0%-20% of the battery voltage difference. Detailed exemplary embodiments and advantages of the method and arrangement according to the invention will now be described with reference to the appended drawings illustrating some preferred embodiments.

### Brief description of the drawings

Fig. 1 schematically shows a traditional battery system.
Fig. 2 schematically shows a prior art battery system.
Fig. 3 schematically shows a dual battery system.
Fig. 4a-d show voltage diagrams for four typical cranking situations.
Fig. 5 shows a flowchart for a method according to the present invention.
Fig. 6 schematically shows an arrangement according to the invention.

### Detailed description of preferred embodiments

In a dual battery system, such as the one generally described in figure 3, each of the starter battery means 330 and the power battery means 320 have an open circuit voltage when the dual circuit breaker 350 is open. Thus, over the starter battery means 330, an open circuit starter battery voltage is present, and over the power battery means 320, an open circuit power battery voltage is present.

By the present invention, it has been realised that the level of at least one of the open circuit starter battery voltage and the open circuit power battery voltage together with a dual system voltage, i.e. the voltage being provided to the system by the starter battery means 330 and the power battery means 320 together when the dual circuit breaker 350 is closed, can be utilised for determining a relative state of health condition for the power battery means 320. Thus, an analysis of the voltage behaviour resulting from the starter battery means 330 and the power battery means 320 before and after closing of the dual circuit breaker 350 can be performed, which offers an accurate estimation of the relative state of health for the power battery means 320. The relative state of health for the power battery means 320 is here related over time to a state of health of the starter battery means 330.

In other words, a relation between the state of health for the power battery means 320 and the starter battery means 330 can according to the present invention be established by the utilizing a determined dual system voltage and one or more of the open circuit power battery voltage and the open circuit starter battery voltage. Usually, the state of health of the starter battery means 330 can be relatively easily determined, and thereby an absolute measure of the state of health can also be determined from the relation between the state of health for the power battery means 320 and the starter battery means 330, which is very useful.

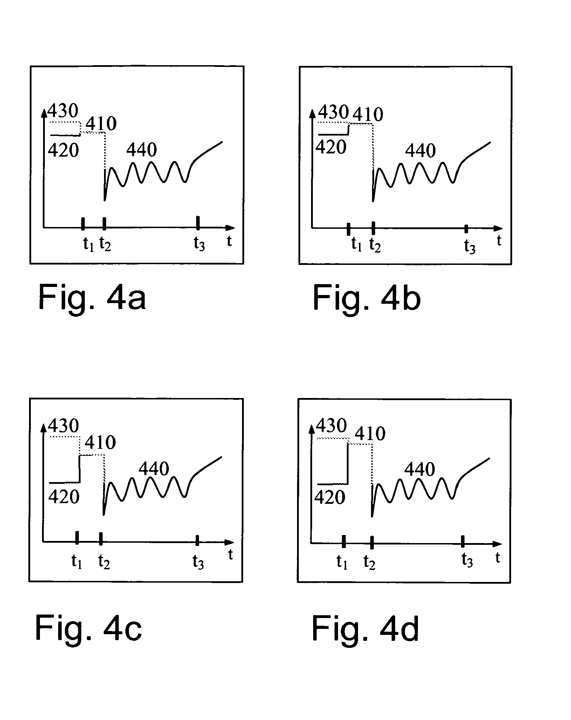

Figures 4a-d generally show exemplary voltage diagrams for a cranking situation for four typical cases for the power and starter battery means, which can be used for illustrating the findings of the present invention. In these voltage diagrams, the open circuit power battery voltage 420 and the open circuit starter battery voltage 430 are shown, respectively. Also, the dual system voltage 410, which is the resulting voltage being provided to the electrical system 310 when the dual circuit breaker 350 is closed at time instant t₁, is shown. Also, the voltage of the dual system voltage during cranking of the starter motor 440, i.e. after time instant t₂ and before time instant t₃, is shown. Figures 4a-d illustrate probable example voltage diagrams for a well balanced battery system. As is clear to a skilled person, the balance of the battery system depends on the design of the system, and the voltage levels and thus the voltage diagrams would be displaced if one of the battery means, e.g. the power battery means, would be very powerful in relation to the other battery means, such that the battery system is not well balanced. The illustration of these voltages for the four cases in figure 4a-d will hereafter be used for explaining the principles of the present invention.

If we assume that the starter battery means 330 is in good condition, i.e. it is essentially fully charged and non-aged, the different cases shown in figures 4a-d can be used for determining a battery condition for the power battery means 320.

In both of the figures 4a-b, the power battery means 320 is relatively fully charged. This is illustrated in these figures by a battery voltage difference, i.e. the voltage difference between the open circuit starter battery voltage 430 and the open circuit power battery voltage 420, being relatively small.

In figure 4a, a case is shown where the power battery means 320 is non-aged, i.e. the at least one power battery is relatively new. This has the consequence that when the dual circuit breaker 350 has been closed at time instant t₁, the dual system voltage 410 has a level being relatively close to the level of the open circuit power battery voltage 420. Thus, if the power battery means 320 is relatively non-aged, a difference between the dual system voltage 410 and the open circuit power battery voltage 420 constitutes a small part of the battery voltage difference. Correspondingly, for the at least one non-aged power battery, a difference between the dual system voltage 410 and the open circuit starter battery voltage 430 constitutes a large portion of the battery voltage difference.

In figure 4b, a case is shown where the power battery means 320 is relatively aged, i.e. the power battery means 320 has been used for a while. When batteries, and thus also the power battery means, performs repeated heavy energy discharges, i.e. performs deep cycling, their inner resistance is increased. Generally, the power battery means is cycled deeper than the starter battery means. Therefore, the level of the dual system voltage will over time get closer and closer to the open circuit starter battery voltage 430. As can be seen in figure 4b, for a relatively aged power battery means, the difference between the dual system voltage 410 and the open circuit power battery voltage 420 makes up a large portion of the battery voltage difference, and, correspondingly, the difference between dual system voltage 410 and the open circuit starter battery voltage 430 is small part of the battery voltage difference.

In both of the figures 4c-d, cases are shown for which the power battery means 320 is relatively poorly charged, i.e. is relatively discharged. This is illustrated in these figures by a battery voltage difference, i.e. the difference between the open circuit starter battery voltage 430 and the open circuit power battery voltage 420, being relatively large.

In figure 4c, a case is shown where the power battery means 320 is relatively non-aged. Therefore, the level of the dual system voltage 410 is such that the difference between the dual system voltage 410 and the open circuit starter battery voltage 430 is a relatively large, i.e. the difference between the dual system voltage 410 and the open circuit starter battery voltage 430 makes up a relatively large portion of the battery voltage difference.

In figure 4d, a case is shown where the power battery means 320 is relatively aged. Therefore, the difference between the dual system voltage 410 and the open circuit power battery voltage 420 makes up a large portion of the battery voltage difference, and, correspondingly, the difference between the dual system voltage 410 and the open circuit starter battery voltage 430 is a small part of the battery voltage difference.

The present invention has recognised that, over time, there is a clear correlation between aging of the power batteries means and the starter battery means, and the sizes of the differences between the dual system voltage 410 and the open circuit power battery voltage and the open circuit starter battery voltage, respectively. Thus, if analysing this correlation over time, a relative state of health for the power battery means can be determined. Here, the determined relative state of health for the power battery means is related to the state of health for the starter battery means. Thus, according to the present invention, this correlation is utilized for determining a relative condition of the power battery means 320.

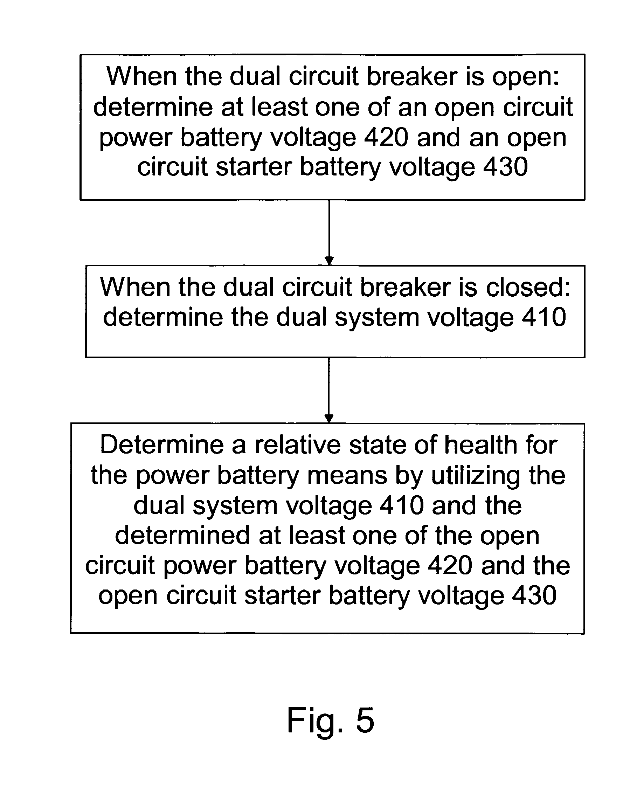

According to the present invention, these findings are utilised in a method for determining a battery condition in a dual battery system. Figure 5 shows a flow chart diagram for a method according to the invention.

In a first step of the method, at least one of the open circuit power battery voltage 420 and the open circuit starter battery voltage 430 is determined when the dual circuit breaker is open, i.e. before time instant t₁.

In a second step of the method, the dual system voltage 410 is determined during a time period when the dual circuit breaker is closed and the starter motor is inactive, i.e. in the time period between the time instants t₁ and t₂.

In a third step of the method, a relative state of health for power battery means is determined by utilizing the determined dual system voltage 410 and the at least one determined one of the open circuit power battery voltage 420 and the open circuit starter battery voltage 430.

Thus, the method of the present invention uses the realized correlation between aging of the power battery means and the levels of the dual system voltage 410 and at least one of the open circuit starter battery voltage 430 and the open circuit power battery voltage 420 for determining a battery condition of the power battery means. The method according to the invention offers an efficient and low complexity determination of the battery conditions, which is especially adapted to the dual battery system.

In particular, the voltages being used in the determination can be easily provided, since they can be measured during relatively long time windows. As was described above, the open circuit power battery voltage 420 can be measured during a long time period before the time instant t₁, and the open circuit starter battery voltage 430 can be measured during a long time period between the time instants t₁ and t₂. There is thus no need for specific currents to run through loads or for synchronising voltage measurements with battery discharges, as was needed in prior art solutions, which makes the method of the present invention much less complex.

According to an embodiment of the invention, the open circuit power battery voltage 420 and/or the open circuit starter battery voltage 430 is determined by performing an estimation of the voltages or by calculating a mean value for the voltages. As is clear to a skilled person, these estimations and mean value calculations may be performed in a number of ways.

According to an embodiment of the present invention, a first difference is defined as a difference between the dual system voltage 410 and the open circuit starter battery voltage 430. This first difference is used for determining the relative state of health for the power battery means, by utilizing how the first difference varies over time. Thus, the determination of the state of health here includes analysis of the varying size of this first difference, from which conclusions can be made, which will be explained below.

According to another embodiment of the present invention, the first difference is instead defined as a difference between the dual system voltage 410 and the open circuit power battery voltage 420. Also here, the first difference is used for determining the relative state of health for the power battery means, by analysis how the size of it varies over time.

According to an embodiment of the invention, when this analysis of the varying size of this first difference shows that the difference between the dual system voltage 410 and the open circuit starter battery voltage 430 decreases over time, it is concluded that the state of health for the power battery means deteriorates relatively to the state of health for the starter battery means. Thus, if, for consecutive measurements of the dual system voltage 410, the open circuit power battery voltage 420, and the open circuit starter battery voltage 430 for consecutive cranking activations, the first difference for the consecutive is reduced over time for these consecutive cranking activations, it can be determined that the state of health for the power battery means gets poorer and poorer in relation to the state of health for the starter battery means.

Since the starter battery means is generally only used for cranking the starter motor, i.e. the dual circuit breaker is closed just before the cranking is started, the starter battery means is in general more or less fully charged. Also, the state of health is in general good for the starter battery means, since these batteries are generally replaced if their state of health is deteriorated. Therefore, the determined relative state of health for the power battery means can often be directly utilized for determining a more or less absolute measure for the state of health for the power battery means, since relative state of health measure for the power battery means is related to the state of health for the starter battery means. Thus, by this low complexity operation resulting in the relative state of health for the power battery means, a very good estimation of the absolute state of health for the power battery means can be determined.

A determined state of health for the starter battery means can be used for determining when it is time to replace the starter battery means in a dual battery system. According to an embodiment of the invention, this determined state of health for the starter battery means is also utilized for determining an absolute state of health for the power battery means. Thus, based on the state of health for the starter battery means and the determined relative state of health for the power battery means, an absolute measure for the state of health for the power battery means can be determined. Thus, if the state of health for the starter battery has already been determined, the relative state of health measure for the power battery means, which relates the state of health for the power battery means to the state of health for the starter battery means, can be used for efficiently determining the absolute measure for the power battery state of health, such that a warning can be indicated in good time before a power battery is useless.

According to an embodiment of the present invention, the state of health for the starter battery means is determined by utilizing one or more parameters for the starter battery means. Analysis of at least one charging process parameter, such as a charging duration, a charging voltage, and a charging current being used when charging the starter battery means, can be used for determining the state of health for the starter battery means. Generally, the vehicle or vessel has or can be made to store information relating such charging process parameters. Thus, this present or stored information can easily be utilized for such determination of the state of health for the starter battery means.

Also, analysis of at least one temperature parameter for the starter battery means can be used for determining the state of health for the starter battery means. In some vehicle or vessel systems, the temperature condition for the starter battery means is measured or estimated. Such temperature conditions can be measured in a number of ways, as is clear for a skilled person, e.g. by using temperature sensors providing temperature related signals. Also, the temperature can be estimated, where the estimation is based on a battery model used for the starter battery means. These measurements and/or estimations can easily be provided to the entity determining the state of health for the starter battery means.

According to an embodiment of the invention, a temperature parameter is measured and/or estimated for each one of the starter battery means and the power battery means. For some implementations, it can be assumed that the starter battery means and the power battery means have essentially the same temperature, or an essentially known or estimated temperature difference. These temperature relations between the starter battery means and the power battery means can then be used for determining the temperature for one of the starter battery means and the power battery means when the other one has been measured or estimated.

Also, analysis of at least one starting process parameter, such as a starting voltage, a time duration used for cranking, a speed of the cranking, and a motor temperature, can be used for determining the state of health for the starter battery means. Such starting process parameters are usually measured in vehicles or vessels of today and are thus available for use by an entity determining the state of health for the starter battery means, which results in a low complexity implementation.

Also, analysis of at least one discharging process parameter, such as a discharging duration, and a discharging current being used when discharging the starter battery means, can be used for determining the state of health for the starter battery means.

According to an embodiment of the present invention, the analysis of the one or more parameters is performed over time. Thus, what is detected is the trend of the state of health for the starter battery means, i.e. the deterioration over time of the state of health. If a severe deterioration is detected hereby, which would mean that the state of health for the starter battery means is poor, this is an indication that it is time for replacing the starter battery means. This indication should be indicated to the driver and/or service mechanic personnel in any suitable way, which is clear to a skilled person.

If the starter battery means is replaced, the replacement has an effect on a number of parameters influencing the battery condition determination. Therefore, the battery condition determination is renewed after such a replacement. Thus, in order to determine a reliable condition determination also after the replacement, certain parameters, such as the state of health for the starter battery means being determined over a period of time, are reset to suitable default values or are at least adjusted to suitable values.

According to an embodiment of the present invention, if the state of health for the starter battery means is determined to be good, i.e. the starter battery means is non-aged, the power battery means is considered to be essentially aged at a point in time if the difference between said dual system voltage 410 and the open circuit starter battery voltage 430 has changed over time to be approximately 0%-30% of the battery voltage difference, and preferably 0%-20% of the battery voltage difference. Here as above, the battery voltage difference is a difference between the open circuit starter battery voltage 430 and the open circuit power battery voltage 420. Generally, the closer the dual system voltage 410 is to the open circuit starter battery voltage 430, the worse is the condition for the power battery means. This is also illustrated in figures 4b and 4d for aged power battery means. As was stated above, these values for the differences between said dual system voltage 410 and the open circuit starter battery voltage 430 depend on how well balanced the system is.

According to an embodiment of the invention, if the power battery means is determined to have a poor state of health, i.e. the state of health of the power battery means has deteriorated to a very low level, this should interpreted as an indication of that it is time to replace the power battery means. As is clear to a skilled person, such an indication can be indicated to the driver and/or service mechanic personnel in a large number of ways. If the power battery means is replaced, the battery condition determination should be restored after the replacement. By this restoration, certain parameters, such as the state of health for the power battery means being determined over a period of time, are reset to suitable default values or are at least adjusted to suitable values in order to not ruin the battery condition determination.

The invention is implemented in an arrangement for determining a battery condition in a dual battery system. As was stated above in connection with figure 3, the dual battery system 300 includes power battery means 320 being connected to an electrical system 310 including a starter motor. The dual battery system 300 also includes a starter battery means 330 being connectable in parallel with the power battery means 320 by a dual circuit breaker 350, whereby, such that the power battery means 320 and the starter battery means 330 provide a dual system voltage 410 to the electrical system 310.

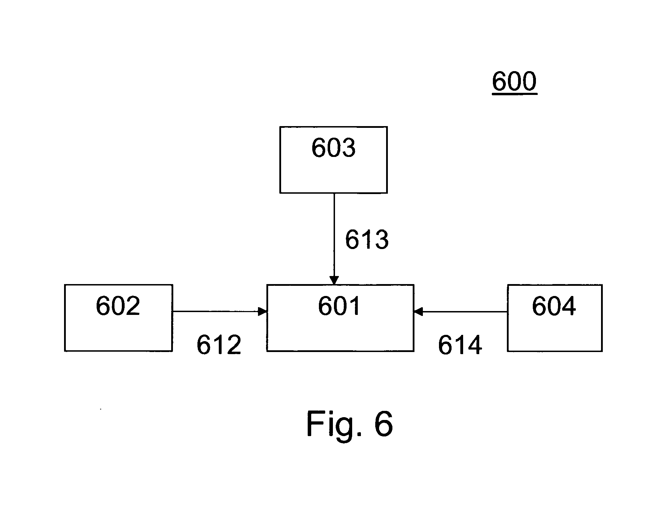

Figure 6 schematically shows such an arrangement 600, including a processing entity 601 performing a number of different calculations and determinations, as will be explained in the following. The arrangement also includes a first voltage determining means 602, which is arranged for determining, when the dual circuit breaker is open, at least one of an open circuit power battery voltage 420 and an open circuit starter battery voltage 430. The first voltage determining means 602 can include, for example two voltmeter devices, each one being arranged for determining the open circuit voltage over the power battery means and the starter battery means, respectively.

The arrangement 600 also includes second voltage determining means 603, arranged for determining the dual system voltage 410 when the dual circuit breaker is closed. The second voltage determining means 603 can include, for example one or more voltmeter devices.

The arrangement 600 can also include an input entity 604, which inputs various information to the processing entity 601. Such information include for example information relating to whether the dual circuit breaker 350 is open or not, if the starter motor is active or not, and the like, which can be utilized by the processing entity 601.

The processing entity 601 includes first state of health determining means, which is arranged for utilizing the determined dual system voltage and the determined at least one of the open circuit power battery voltage and the open circuit starter battery voltage for determining the relative state of health for the power battery means. As stated above, the relative state of health is related over time to a state of health for the starter battery means.

According to an embodiment of the invention, the processing entity also includes second state of health determining means, is arranged for determining the state of health for the starter battery means. Also, the processing entity includes absolute state of health determining means, which is arranged for determining, for a point in time an absolute measure of the state of health for the power battery means, where that absolute determination is based on the state of health for the starter battery means and on the relative state of health for the power battery means.

According to an embodiment of the invention, the arrangement also includes one or more means for determining parameters. Here, one or more of the following parameter determining means provides parameters to the input entity 604; means for determining at least one charging process parameter, means for determining at least one battery means temperature parameter, means for determining at least one starting process parameter, and means for determining at least one discharging process parameter.

As is clear to a skilled person, the arrangement 600 of the invention can be adapted to include means for performing any of the steps of the method of the invention. A trivial requirement is of course that the arrangement is provided with necessary information needed for performing such a step.

The means being included in the processing entity, i.e. the first and second voltage determining means, the first and second state of health determining means, and the absolute state of health determining means could be different physical or logical parts of the processing entity, such as different chips of parts of the same chip, and different parts of a programming code or different executions of the same programming code.

The connection means 612, 613, and 614 in figure 6 can each be either one in the group of a cable; a bus, such as a Controller Area Network (CAN) bus, a Media Orientated Systems Transport (MOST) bus, or the like, or a wireless connection. The processing entity 601 can be located in connection with the driver compartment or can be located in essentially any other part of the vehicle.

The method of the invention can be implemented by a computer program, having code means, which when run in a computer causes the computer to execute the steps of the method. The computer program is included in a computer readable medium of a computer program product. The computer readable medium may consist of essentially any memory, such as a ROM (Read-Only Memory), a PROM (Programmable Read-Only Memory), an EPROM (Erasable PROM), a Flash memory, an EEPROM (Electrically Erasable PROM), or a hard disk drive.

As is obvious for a skilled person, a number of other implementations, modifications, variations and/or additions can be made to the above described exemplary embodiments. It is to be understood that the invention includes all such other implementations, modifications, variations and/or additions which fall within the scope of the claims.

## Claims

1. Method for battery condition determination in a dual battery system of a vehicle, said dual battery system including:
- power battery means being connected to an electrical system (310) including a starter motor, and
- starter battery means being connectable in parallel with said power battery means by a circuit breaker, whereby, when said circuit breaker is closed, said power battery means and said starter battery means provide a dual system voltage to the electrical system,
**characterized by** the following steps being performed during a time period when a starter motor is inactive:
- determining, when said circuit breaker is open, at least one of an open circuit power battery voltage and an open circuit starter battery voltage,
- determining, when said dual circuit breaker is closed, said dual system voltage, and
- utilizing said dual system voltage and the determined at least one of said open circuit power battery voltage and said open circuit starter battery voltage for determining a relative state of health for said power battery means, said relative state of health being related over time to a state of health for said starter battery means, where the state of health for said starter battery means is presumed to be good, and wherein a variation in size over time of a first difference is utilized for determining said relative state of health for said power battery means, said first difference being a difference between said dual system voltage and said open circuit power battery voltage, and wherein said state of health for said power battery means is considered to deteriorate relatively to said state of health for said starter battery means if said first difference varies such that a difference between said dual system voltage and said open circuit starter battery voltage decreases over time.

2. Method as claimed in claim 1, wherein a variation in size over time of a first difference is utilized for determining said relative state of health for said power battery means, said first difference being a difference between said dual system voltage and said open circuit starter battery voltage.

3. Method as claimed in any one of claims 1-2, further including the steps of:
- determining said state of health for said starter battery means, and
- determining, for a point in time, based on said state of health for said starter battery means and on said relative state of health for said power battery means, an absolute measure of said state of health for said power battery means.

4. Method as claimed in claim 3, wherein the determination of said state of health for said starter battery means includes utilization of at least one starter battery means parameter in the group of:
- at least one charging process parameter;
- at least one starter battery means temperature parameter;
- at least one starting process parameter; and
- at least one discharging process parameter.

5. Method as claimed in claim 4, wherein said utilization of said at least one parameter is performed over time, such that a deterioration over time of said state of health for said starter battery means is detected.

6. Method as claimed in any one of claims 3-5, wherein said power battery means is considered to be essentially aged for said point in time if, when said state of health for said starter battery means is good, said difference between said dual system voltage and said open circuit starter battery voltage is reduced to approximately 0%-30% of a battery voltage difference, and preferably 0%-20% of said battery voltage difference, wherein said battery voltage difference is a difference between said open circuit starter battery voltage and said open circuit power battery voltage.

7. Method as claimed in anyone of claims 3-5, wherein a determined poor state of said health for at least one of said starter battery means and said power battery means is interpreted as an indication of that it is time to replace at least one of said starter battery means and said power battery means, respectively.

8. Method as claimed in anyone of claims 1-7, wherein said battery condition determination is renewed if at least one of said starter battery means and said power battery means is replaced.

9. Computer program, **characterized in** code means, which when run in a computer causes the computer to execute the method according to any of the claims 1-8.

10. Computer program product including a computer readable medium and a computer program according to claim 9, wherein said computer program is included in the computer readable medium.

11. Arrangement for determining a battery condition in a dual battery system, said dual battery system including:
- power battery means being connected to an electrical system (310) including a starter motor, and
- starter battery means being connectable in parallel with said power battery means by a circuit breaker, whereby, when said circuit breaker is closed, said power battery means and said starter battery means provide a dual system voltage to the electrical system,
**characterized by**
- first voltage determining means, being arranged for determining, when said circuit breaker is open, at least one of an open circuit power battery voltage and an open circuit starter battery voltage,
- second voltage determining means, arranged for determining, when said circuit breaker is closed, said dual system voltage, - first state of health determining means, being arranged for utilizing said dual system voltage and the determined at least one of said open circuit power battery voltage and said open circuit starter battery voltage for determining a relative state of health for said power battery means, said relative state of health being related over time to a state of health for said starter battery means, where the state of health for said starter battery means is presumed to be good, and
- the first state of health determining means are further arranged to utilize a variation in size over time of a first difference for determining said relative state of health for said power battery means, said first difference being a difference between said dual system voltage and said open circuit power battery voltage, and to determine that said state of health for said power battery means is considered to deteriorate relatively to said state of health for said starter battery means if said first difference varies such that a difference between said dual system voltage and said open circuit starter battery voltage decreases over time.

12. Arrangement as claimed in claim 11, wherein said arrangement includes
- second state of health determining means, being arranged for determining said state of health for said starter battery means, and
- absolute state of health determining means, being arranged for determining, for a point in time, based on said state of health for said starter battery means and on said relative state of health for said power battery means, an absolute measure of said state of health for said power battery means.

13. Arrangement as claimed in claim 11, wherein said arrangement includes at least one means in the group of:
- means for determining at least one charging process parameter;
- means for determining at least one battery means temperature parameter;
- means for determining at least one starting process parameter; and
- means for determining at least one discharging process parameter.

## Patentansprüche

1. Verfahren zum Ermitteln eines Batteriezustandes in einem Zwei-Batteriensystem eines Fahrzeugs, wobei das Zwei-Batteriensystem umfasst:
- Leistungsbatteriemittel, die mit einem elektrischen System (310) verbunden sind, das einen Startermotor umfasst, und
- Starterbatteriemittel, die mittels eines Leistungsschutzschalters mit den Leistungsbatteriemitteln parallel geschaltet werden können, wodurch die Leistungsbatteriemittel und die Starterbatteriemittel dem elektrischen System eine Dual-Systemspannung bereitstellen, wenn der Leistungsschutzschalter geschlossen ist,
**dadurch gekennzeichnet, dass**
die nachfolgenden Schritte während einer Zeitdauer durchgeführt werden, wenn ein Startermotor inaktiv ist:
- Ermitteln zumindest entweder einer Leerlaufleistungsbatteriespannung oder einer Leerlaufstarterbatteriespannung, wenn der Leistungsschutzschalter geöffnet ist,
- Ermitteln der Dual-Systemspannung, wenn der Leistungsschutzschalter geschlossen ist, und
- Verwenden der Dual-Systemspannung und zumindest entweder der ermittelten Leerlaufleistungsbatteriespannung oder der ermittelten Leerlaufstarterbatteriespannung zum Ermitteln eines relativen Alterungszustandes für die Leistungsbatteriemittel, wobei sich der relative Alterungszustand im Zeitablauf auf einen Alterungszustand für die Starterbatteriemittel bezieht, wobei der Alterungszustand für die Starterbatteriemittel als gut gilt, und wobei eine Größenänderung einer ersten Differenz im Zeitablauf verwendet wird, um den relativen Alterungszustand für die Leistungsbatteriemittel zu ermitteln, wobei die erste Differenz eine Differenz zwischen der Dual-Systemspannung und der Leerlaufleistungsbatteriespannung ist, und wobei der Alterungszustand für die Leistungsbatteriemittel als sich verschlechternd relativ zu dem Alterungszustand für die Starterbatteriemittel angesehen wird, wenn die erste Differenz sich derart ändert, dass eine Differenz zwischen der Dual-Systemspannung und der Leerlaufstarterbatteriespannung im Zeitablauf abnimmt.

2. Verfahren nach Anspruch 1, bei dem eine Größenänderung einer ersten Differenz im Zeitablauf verwendet wird, um den relativen Alterungszustand für die Leistungsbatteriemittel zu ermitteln, wobei die erste Differenz eine Differenz zwischen der Dual-Systemspannung und der Leerlaufstarterbatteriespannung ist.

3. Verfahren nach einem der Ansprüche 1-2, das ferner die Schritte umfasst:
- Ermitteln des Alterungszustandes für die Starterbatteriemittel, und
- Ermitteln einer absoluten Messgröße für den Alterungszustand für die Leistungsbatteriemittel für einen Zeitpunkt auf Grundlage des Alterungszustandes für die Starterbatteriemittel und des relativen Alterungszustandes für die Leistungsbatteriemittel.

4. Verfahren nach Anspruch 3, bei dem das Ermitteln des Alterungszustandes für die Starterbatteriemittel ein Verwenden zumindest eines Starterbatteriemittelparameters aus der folgenden Gruppe umfasst:
- zumindest ein Ladevorgangparameter;
- zumindest ein Starterbatteriemitteltemperaturparameter;
- zumindest ein Startvorgangparameter; und
- zumindest ein Entladevorgangparameter.

5. Verfahren nach Anspruch 4, bei dem das Verwenden des zumindest einen Parameters derart im Zeitablauf erfolgt, dass ein Verschlechtern im Zeitablauf des Alterungszustandes für die Starterbatteriemittel ermittelt wird.

6. Verfahren nach einem der Ansprüche 3-5, bei dem die Leistungsbatteriemittel als wesentlich gealtert für den Zeitpunkt angesehen werden, wenn die Differenz zwischen der Dual-Systemspannung und der Leerlaufstarterbatteriespannung auf etwa 0%-30% einer Batteriespannungsdifferenz, und vorzugsweise auf 0%-20% der Batteriespannungsdifferenz reduziert wird, wenn der Alterungszustand für die Starterbatteriemittel gut ist, wobei die Batteriespannungsdifferenz eine Differenz zwischen der Leerlaufstarterbatteriespannung und der Leerlaufleistungsbatteriespannung ist.

7. Verfahren nach einem der Ansprüche 3-5, bei dem ein ermittelter schlechter Zustand für die Alterung für zumindest entweder die Starterbatteriemittel oder die Leistungsbatteriemittel als ein Indikator dafür angesehen wird, dass es an der Zeit ist, zumindest entweder jeweils die Starterbatteriemittel oder die Leistungsbatteriemittel auszutauschen.

8. Verfahren nach einem der Ansprüche 1-7, bei dem das Ermitteln des Batteriezustandes wiederholt wird, wenn zumindest entweder die Starterbatteriemittel oder die Leistungsbatteriemittel ausgetauscht werden.

9. Computerprogramm, das durch ein Kodiermittel gekennzeichnet ist, das einen Computer dazu bewirkt, das Verfahren nach einem der Ansprüche 1-8 durchzuführen, wenn das Kodiermittel in dem Computer ausgeführt wird.

10. Computerprogrammprodukt, das ein computerlesbares Medium und ein Computerprogramm nach Anspruch 9 umfasst, wobei das Computerprogramm in dem computerlesbaren Medium umfasst ist.

11. Vorrichtung zum Ermitteln eines Batteriezustandes in einem Zwei-Batteriensystem, wobei das Zwei-Batteriensystem umfasst:
- Leistungsbatteriemittel, die mit einem elektrischen System (310) verbunden sind, das einen Startermotor umfasst, und
- Starterbatteriemittel, die mittels eines Leistungsschutzschalters mit dem Leistungsbatteriemittel parallel geschaltet werden können, wodurch die Leistungsbatteriemittel und die Starterbatteriemittel dem elektrischen System eine Dual-Systemspannung bereitstellen, wenn der Leistungsschutzschalter geschlossen ist, **dadurch gekennzeichnet, dass**
- erste Spannungsbestimmungsmittel dazu eingerichtet sind, zumindest entweder eine Leerlaufleistungsbatteriespannung oder eine Leerlaufstarterbatteriespannung zu ermitteln, wenn der Leistungsschutzschalter geöffnet ist,
- zweite Spannungsbestimmungsmittel dazu eingerichtet sind, die Dual-Systemspannung zu ermitteln, wenn der Leistungsschutzschalter geschlossen ist,
- erste Alterungszustandsbestimmungsmittel dazu eingerichtet sind, die Dual-Systemspannung und zumindest entweder die ermittelte Leerlaufleistungsbatteriespannung oder die ermittelte Leerlaufstarterbatteriespannung zu verwenden, um einen relativen Alterungszustand für die Leistungsbatteriemittel zu bestimmen, wobei der relative Alterungszustand im Zeitablauf einem Alterungszustand für die Starterbatteriemittel entspricht, wobei der Alterungszustand für die Starterbatteriemittel als gut gilt, und
- die ersten Alterungszustandsbestimmungsmittel ferner dazu eingerichtet sind, eine Größenänderung einer ersten Differenz im Zeitablauf zu verwenden, um den relativen Alterungszustand für die Leistungsbatteriemittel zu bestimmen, wobei die erste Differenz eine Differenz zwischen der Dual-Systemspannung und der Leerlaufleistungsbatteriespannung ist, und zu bestimmen, dass der Alterungszustand für die Leistungsbatteriemittel als sich verschlechternd relativ zu dem Alterungszustand für die Starterbatteriemittel anzusehen ist, wenn die erste Differenz sich derart ändert, dass eine Differenz zwischen der Dual-Systemspannung und der Leerlaufstarterbatteriespannung im Zeitablauf abnimmt.

12. Vorrichtung nach Anspruch 11, wobei die Vorrichtung umfasst:
- zweite Alterungszustandsbestimmungsmittel, die zum Ermitteln des Alterungszustandes für die Starterbatteriemittel eingerichtet sind, und
- Alterungsabsolutzustandsbestimmungsmittel, die dazu eingerichtet sind, eine absolute Messgröße für den Alterungszustand für die Leistungsbatteriemittel zu einem Zeitpunkt auf Grundlage des Alterungszustandes für die Starterbatteriemittel und des relativen Alterungszustandes für die Leistungsbatteriemittel zu ermitteln.

13. Vorrichtung nach Anspruch 11, bei der die Vorrichtung zumindest ein Mittel aus der folgenden Gruppe umfasst:
- Mittel zum Bestimmen zumindest eines Ladevorgangparameters;
- Mittel zum Bestimmen zumindest eines Batteriemitteltemperaturparameters;
- Mittel zum Bestimmen zumindest eines Startvorgangparameters; und
- Mittel zum Bestimmen zumindest eines Entladevorgangparameters.

## Revendications

1. Procédé de détermination de condition de batterie dans un système à double batterie d'un véhicule, ledit système à double batterie comprenant :
- des moyens formant batterie de puissance, qui sont connectés à un système électrique (310) comprenant un moteur de démarreur, et
- des moyens formant batterie de démarreur, qui peuvent être connectés en parallèle auxdits moyens formant batterie de puissance par un coupe-circuit, grâce à quoi, lorsque ledit coupe-circuit est fermé, lesdits moyens formant batterie de puissance et lesdits moyens formant batterie de démarreur délivrent une tension d'un système-double au système électrique,
**caractérisé en ce que** les étapes suivantes sont effectuées durant une période de temps pendant laquelle un moteur de démarreur est inactif :
- la détermination, lorsque ledit coupe-circuit est ouvert, d'au moins l'une d'une tension de batterie de puissance en circuit ouvert et d'une tension de batterie de démarreur en circuit ouvert,
- la détermination, lorsque ledit coupe-circuit est fermé, de ladite tension de système-double, et
- l'utilisation de ladite tension de système-double et d'au moins l'une de ladite tension de batterie de puissance en circuit ouvert et de ladite tension de batterie de démarreur en circuit ouvert déterminées pour déterminer un état de santé relatif pour lesdits moyens formant batterie de puissance, ledit état de santé relatif étant associé au cours du temps à un état de santé pour lesdits moyens formant batterie de démarreur, l'état de santé desdits moyens formant batterie de démarreur étant supposé être bon, et une variation de taille au cours du temps d'une première différence étant utilisée pour déterminer ledit état de santé relatif pour lesdits moyens formant batterie de puissance, ladite première différence étant une différence entre ladite tension de système-double et ladite tension de batterie de puissance en circuit ouvert, et ledit état de santé pour lesdits moyens formant batterie de puissance étant considéré comme se détériorant par rapport audit état de santé pour lesdits moyens formant batterie de démarreur si ladite première différence varie de telle sorte qu'une différence entre ladite tension de système-double et ladite tension de batterie de démarreur en circuit ouvert diminue au cours du temps.

2. Procédé selon la revendication 1, dans lequel une variation de taille au cours du temps d'une première différence est utilisée pour déterminer ledit état de santé relatif pour lesdits moyens formant batterie de puissance, ladite première différence étant une différence entre ladite tension de système-double et ladite tension de batterie de démarreur en circuit ouvert.

3. Procédé selon l'une quelconque des revendications 1 à 2, comprenant de plus les étapes consistant à :
- déterminer ledit état de santé pour lesdits moyens formant batterie de démarreur, et
- déterminer, pour un point dans le temps, en fonction dudit état de santé pour lesdits moyens formant batterie de démarreur et dudit état de santé relatif pour lesdits moyens formant batterie de puissance, une mesure absolue dudit état de santé pour lesdits moyens formant batterie de puissance.

4. Procédé selon la revendication 3, dans lequel la détermination dudit état de santé pour lesdits moyens formant batterie de démarreur comprend l'utilisation d'au moins un paramètre de moyens formant batterie de démarreur dans le groupe comprenant :
- au moins un paramètre de processus de charge ;
- au moins un paramètre de température de moyens formant batterie de démarreur ;
- au moins un paramètre de processus de démarrage ; et
- au moins un paramètre de processus de décharge.

5. Procédé selon la revendication 4, dans lequel ladite utilisation dudit paramètre au nombre d'au moins un est effectuée au cours du temps, de telle sorte qu'une détérioration au cours du temps dudit état de santé pour lesdits moyens formant batterie de démarreur soit détectée.

6. Procédé selon l'une quelconque des revendications 3 à 5, dans lequel lesdits moyens formant batterie de puissance sont considérés comme étant essentiellement vieillis pour ledit point dans le temps si, lorsque ledit état de santé pour lesdits moyens formant batterie de démarreur est bon, ladite différence entre ladite tension de système-double et ladite tension de batterie de démarreur en circuit ouvert est réduite à approximativement 0 % à 30 % d'une différence de tension de batterie, et, de préférence, à 0 % à 20 % de ladite différence de tension de batterie, ladite différence de tension de batterie étant une différence entre ladite tension de batterie de démarreur en circuit ouvert et ladite tension de batterie de puissance en circuit ouvert.

7. Procédé selon l'une quelconque des revendications 3 à 5, dans lequel un état médiocre déterminé de ladite santé pour au moins l'un desdits moyens formant batterie de démarreur et desdits moyens formant batterie de puissance est interprété comme une indication du fait qu'il est temps de remplacer au moins l'un desdits moyens formant batterie de démarreur et desdits moyens formant batterie de puissance, respectivement.

8. Procédé selon l'une quelconque des revendications 1 à 7, dans lequel ladite détermination de condition de batterie est renouvelée si au moins l'un desdits moyens formant batterie de démarreur et desdits moyens formant batterie de puissance sont remplacés.

9. Programme informatique, **caractérisé par** des moyens formant code, qui, lorsqu'ils sont exécutés dans un ordinateur, provoquent l'exécution par l'ordinateur du procédé selon l'une quelconque des revendications 1 à 8.

10. Produit de programme informatique comprenant un support lisible par un ordinateur et un programme informatique selon la revendication 9, dans lequel ledit programme informatique est inclus dans le support lisible par un ordinateur.

11. Agencement pour déterminer une condition de batterie dans un système à double batterie, ledit système à double batterie comprenant :
- des moyens formant batterie de puissance, qui sont connectés à un système électrique (310) comprenant un moteur de démarreur, et
- des moyens formant batterie de démarreur, qui peuvent être connectés en parallèle auxdits moyens formant batterie de puissance par un coupe-circuit, grâce à quoi, lorsque ledit coupe-circuit est fermé, lesdits moyens formant batterie de puissance et lesdits moyens formant batterie de démarreur délivrent une tension de système-double au système électrique,
**caractérisé par** :
- des premiers moyens de détermination de tension, qui sont configurés de façon à déterminer, lorsque ledit coupe-circuit est ouvert, au moins l'une d'une tension de batterie de puissance en circuit ouvert et d'une tension de batterie de démarreur en circuit ouvert,
- des deuxièmes moyens de détermination de tension, configurés de façon à déterminer, lorsque ledit coupe-circuit est fermé, ladite tension de système-double,
- des premiers moyens de détermination d'état de santé, qui sont configurés de façon à utiliser ladite tension de système-double et au moins l'une de ladite tension de batterie de puissance en circuit ouvert et de ladite tension de batterie de démarreur en circuit ouvert déterminées pour déterminer un état de santé relatif pour lesdits moyens formant batterie de puissance, ledit état de santé relatif étant associé au cours du temps à un état de santé pour lesdits moyens formant batterie de démarreur, l'état de santé pour lesdits moyens formant batterie de démarreur étant supposé être bon, et
- les premiers moyens de détermination d'état de santé étant de plus configurés de façon à utiliser une variation de taille au cours du temps d'une première différence pour déterminer ledit état de santé relatif pour lesdits moyens formant batterie de puissance, ladite première différence étant une différence entre ladite tension de système-double et ladite tension de batterie de puissance en circuit ouvert, et pour déterminer que ledit état de santé pour lesdits moyens formant batterie de puissance est considéré comme se détériorant par rapport audit état de santé pour lesdits moyens formant batterie de démarreur si ladite première différence varie de telle sorte qu'une différence entre ladite tension de système-double et ladite tension de batterie de démarreur en circuit ouvert diminue au cours du temps.

12. Agencement selon la revendication 11, dans lequel ledit agencement comprend :
- des deuxièmes moyens de détermination d'état de santé, qui sont configurés de façon à déterminer ledit état de santé pour lesdits moyens formant batterie de démarreur, et
- des moyens de détermination d'état de santé absolu, qui sont configurés de façon à déterminer, pour un point dans le temps, en fonction dudit état de santé pour lesdits moyens formant batterie de démarreur et dudit état de santé relatif pour lesdits moyens formant batterie de puissance, une mesure absolue dudit état de santé pour lesdits moyens formant batterie de puissance.

13. Agencement selon la revendication 11, dans lequel ledit agencement comprend au moins un moyen dans le groupe comprenant :
- des moyens pour déterminer au moins un paramètre de processus de charge ;
- des moyens pour déterminer au moins un paramètre de température de moyens formant batterie ;
- des moyens pour déterminer au moins un paramètre de processus de démarrage ; et
- des moyens pour déterminer au moins un paramètre de processus de décharge.
